(19) **Europäisches Patentamt**

**European Patent Office**

**Office européen des brevets**

(11) Veröffentlichungsnummer: **0 149 785**
**B1**

(12) # EUROPÄISCHE PATENTSCHRIFT

(45) Veröffentlichungstag der Patentschrift:
**22.06.88**

(21) Anmeldenummer: **84115135.0**

(22) Anmeldetag: **11.12.84**

(51) Int. Cl.⁴: **H 03 H 21/00,** H 04 L 25/03

(54) **Verfahren und Schaltungsanordnung zur Digitalsignalverarbeitung nach Art eines vorzugsweise adaptiven Transversalfilters.**

(30) Priorität: **14.12.83 DE 3345284**

(43) Veröffentlichungstag der Anmeldung:
**31.07.85 Patentblatt 85/31**

(45) Bekanntmachung des Hinweises auf die Patenterteilung:
**22.06.88 Patentblatt 88/25**

(84) Benannte Vertragsstaaten:
**AT BE CH DE FR GB IT LI NL SE**

(56) Entgegenhaltungen:
**US - A - 4 374 426**

**IEE PROCEEDINGS, Band 128, Teil F, Nr. 4, August 1981,
Seiten 225-230, Old Woking, GB; C.F.N. COWAN u.a.:
"New digital adaptive-filter implementation using
distributed-arithmetic techniques"**

(73) Patentinhaber: **Siemens Aktiengesellschaft Berlin und München, Wittelsbacherplatz 2, D-8000 München 2 (DE)**

(72) Erfinder: **Schenk, Heinrich, Dr.,
Becker-Gundahl-Strasse 1, D-8000 München 71 (DE)**

## Beschreibung

In Digital-Fernmeldesystemen können bei der Signalübertragung lineare Signalverzerrungen entstehen, zu deren Entzerrung adaptive Entzerrer (und auch Kompromissentzerrer) einzusetzen sind, die üblicherweise mit Transversalfiltern realisiert werden. Ein solches Transversalfilter ist eine eingangsseitig schrittweise mit dem zu verarbeitenden Signal beaufschlagte Laufzeitkette, die vor und hinter jeder – jeweils einem Laufzeitschritt entsprechenden – Stufe mit Abgriffen versehen ist, wobei bei jedem Laufzeitschritt die an den Abgriffen jeweils auftretenden Abgriffssignalelemente nach Massgabe von abgriffsindividuellen Filterkoeffizienten bewertet (multipliziert), d.h. gegebenenfalls verstärkt, gedämpft und/oder vorzeichenverändert, und so zu dem gefilterten Ausgangssignalelement aufsummiert werden; die Filterkoeffizienten können bei einem sog. adaptiven Transversalfilter nach Massgabe eines Fehlersignals adaptiv eingestellt werden (NTZ 24 (1971) 1, 18–24; Bocker: Datenübertragung, 1976, Bd. 1, Kap. 5.3.2) oder aber fest eingestellt sein (Kompromissfilter). Ausser zur Signalentzerrung können Transversalfilter auch in Übersprech- und/oder Echokompensationsschaltungen zur Störsignalkompensation eingesetzt werden (AGARD Conf. Proc. No. 103 (1972), 12-1–12-16; Der Fernmelde-Ingenieur 31 (1977) 12, 1–25, 21; BSTJ 58 (1979) 2, 491–500, 493).

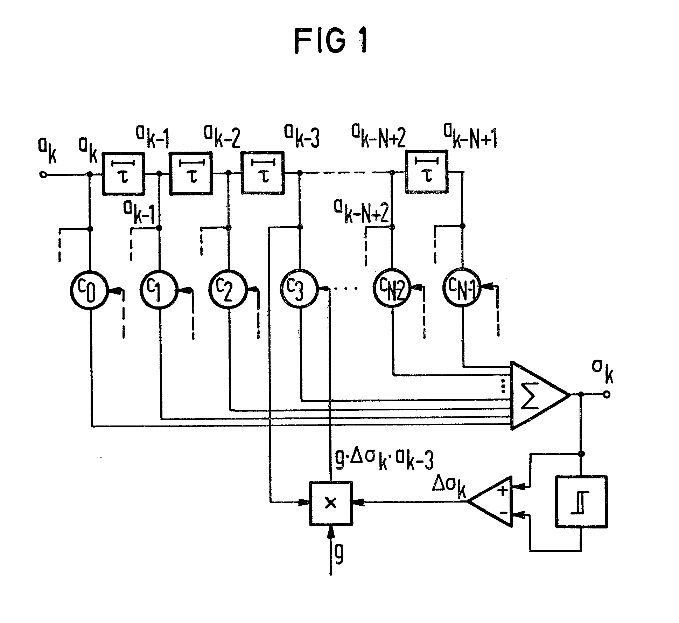

In einem (N-1)-stufigen Transversalfilter, wie es in Fig. 1 skizziert ist, lässt sich der Wert des in einem Zeitelement k erhaltenen Ausgangssignalelements $\sigma_k$ mit

$$\sigma_k = \sum_{i=0}^{N-1} a_{k-i} \cdot c_i$$

beschreiben, worin $a_{k-i}$ die Werte der in diesem Zeitelement an den einzelnen Abgriffen der Laufzeitkette auftretenden Abgriffssignalelemente und $c_i$ die N Filterkoeffizienten bedeuten, die die Eigenschaften (Frequenzgang, Zeitverhalten) des Filters bestimmen. Bei adaptiver Filtereinstellung können die einzelnen Filterkoeffizienten $c_i$ schrittweise in einer Iteration eingestellt werden, die sich etwa mit

$$c_{i(k+1)} = c_{i(k)} - g \cdot \triangle \sigma_k \cdot a_{k-i}$$

beschreiben lässt, worin g die sog. Verstellgrösse darstellt, die die Einlaufzeit des Filters in den gewünschten Zustand und die erforderliche Koeffizientenwortlänge und damit die Filtergenauigkeit bestimmt, die aber zur Gewährleistung eines sicheren Einlaufens (Filterkonvergenz) auch nicht so gross gewählt werden darf; $\triangle \sigma_k$ ist der gegenüber einem angestrebten Sollwert verbliebene Fehler des gerade betrachteten Ausgangssignalelements. Statt eines solchen Fehlers kann ggf. auch nur dessen Vorzeichen sgn ($\triangle \sigma_k$) als Einstellkriterium verwendet werden.

Für die Realisierung eines solchen Transversalfilters sind N Koeffizientenspeicher erforderlich, und es sind bei Verarbeitung von binären oder ternären Digitalsignalen je Laufzeitschritt, d.h. in jedem Zeitelement, N nach Massgabe der gespeicherten Filterkoeffizienten bewertete Abgriffssignalelemente aufzusummieren, d.h. (maximal) N Additionen bzw. Subtraktionen durchzuführen; bei der adaptiven Einstellung der Filterkoeffizienten sind je Laufzeitschritt N Korrekturwerte für die N Koeffizienten zu berechnen. Dies setzt eine der Länge des Transversalfilters, d.h. der Grösse von N, entsprechende hohe Verarbeitungsgeschwindigkeit voraus, die indessen aus technologischen Gründen nicht immer gegeben sein wird.

Der Erfindung liegt demgegenüber die Aufgabe zugrunde, ein Verfahren und eine Schaltungsanordnung anzugeben, mit dem/der eine Digitalsignalverarbeitung nach Art eines vorzugsweise adaptiven Transversalfilters mit einer (N-1)-stufigen Laufzeitkette auch bei geringeren Verarbeitungsgeschwindigkeiten ermöglicht wird.

Geringere Verarbeitungsgeschwindigkeiten ermöglicht an sich ein (aus IEE Proc., Vol. 128, Part F, No. 4, August 1981, 225–230), bekanntes transversales Digitalfilter, das nach dem Prinzip der verteilten Arithmetik arbeitet: Ein solches Digitalfilter nimmt Eingangsworte (= jeweils durch eine k-stellige Dualzahl codiert dargestellte Abtastwerte) seriell auf und verarbeitet diese Worte innerhalb der Wortzeitspanne T (= Abtastperiode) zusammen mit N-1 vorangehenden, jeweils ein wortlanges Schieberegister durchlaufenden Eingangsworten Bit nach Bit, indem jeweils bitstellenindividuell aus einem mit den in allen diesen N Worten an der betreffenden Bitstelle auftretenden Bits adressiert angesteuerten Festwertspeicher eine Teilsumme ausgelesen wird; zur bitstellenrichtigen Addition bitstellenindividueller Teilsummen zu der dem Eingangswort (nach Filterung) entsprechenden, das Ausgangswort bildenden Gesamtsumme ist ggf. vor jeder Addition mit einer nächsthöherstelligen Teilsumme eine Division durch 2 (d.i. eine Verschiebung um eine Bitstelle nach unten) erforderlich.

Ein solches nach dem Prinzip der verteilten Arithmetik arbeitendes Digitalfilter erfordert allerdings eine Speicherkapazität von $2^N$ Teilsummen; die Erfindung zeigt demgegenüber einen Weg, eine Digitalsignalverarbeitung nach Art eines vorzugsweise adaptiven Transversalfilters mit einer (N-1)-stufigen Laufzeitkette unter Abspeicherung von Teilsummensignalen auch mit einer merklich geringeren Speicherkapazität zu ermöglichen.

Die Erfindung betrifft ein Verfahren zur Digitalsignalverarbeitung nach Art eines vorzugsweise adaptiven Transversalfilters mit einer eingangsseitig mit dem zu verarbeitenden Digitalsignal beaufschlagten, mit Abgriffen versehenen (N-1)-stufigen Laufzeitkette, unter Abspeicherung von Teilsummensignalen, die aus jeweils einer Gruppe gleichzeitig abgreifbarer, nach Massgabe der jeweiligen Filtereinstellung bewerteter Abgriffssignalelemente gebildet sind, wobei während der Laufzeitschritte nach Massgabe der tatsächlichen Kombinationen von Abgriffssignalelementen die zugehörigen Teilsummensignale sukzessive ausgelesen und miteinander zu Ausgangssignalelementen aufsummiert werden. Dieses Verfahren ist erfindungsgemäss gekennzeichnet durch die Abspeicherung solcher Teilsummensignale, die N/w (mit w < N) aufeinanderfolgenden Gruppen von jeweils $A^w$ möglichen Kombinationen jeweils w aufeinanderfolgender A-wertiger Abgriffssignalelemente entsprechen, und dadurch, dass während jedes Laufzeitschrittes N/w aufeinanderfolgende Gruppen jeweils w aufeinanderfolgender Abgriffssignalelemente sukzessive abgegriffen werden und nach Massgabe der jeweiligen N/w tatsächlichen Kombinationen von Abgriffssignalelementen die zugehörigen Teilsummensignale sukzessive ausgelesen und miteinander zu einem Ausgangssignalelement aufsummiert werden; in weiterer Ausgestaltung der Erfindung ist die iterative Bildung von Teilsummensignalen dadurch vorgesehen, dass jedes der sukzessive ausgelesenen Teilsummensignale mit einem Korrekturwert kombiniert ein korrigiertes Teilsummensignal bildet, das anstelle des ausgelesenen Teilsummensignals als neues Teilsummensignal abgespeichert wird.

Die Erfindung, die bei der Aufsummierung der bewerteten Abgriffssignalelemente zum jeweiligen Ausgangssignalelement jeweils Gruppen von je w (mit w < N) bewerteter Abgriffssignalelementen zusammengefasst behandelt und lediglich deren – abgespeicherte – Teilsummensignale aufsummiert, bringt neben dem Vorteil, je Laufzeitschritt, d.h. je Zeitelement, nur N/w arithmetische Operationen durchführen zu müssen, den weiteren Vorteil mit sich, bei der Abspeicherung der Teilsummen mit einer Speicherkapazität von allenfalls $A^w \cdot N/w$ Teilsummen auskommen zu können; bei der Filtereinstellung sind jeweils N/w Korrekturwerte zu bestimmen, die sich auf die genannten Teilsummensignale beziehen, die ihrerseits sowohl vom gewünschten Filterverhalten als auch von den in die Laufzeitkette eingegebenen Digitalsignalelementen abhängig sind.

Bei der iterativen Bildung von Teilsummensignalen können während jedes Laufzeitschrittes die einzelnen Teilsummensignale jeweils nach Massgabe des während dieses Laufzeitschrittes auftretenden, mit einer Stellgrösse bewerteten Ausgangssignalfehlers korrigiert werden; in weiterer Ausgestaltung der Erfindung ist es aber auch möglich, die einzelnen Teilsummensignale jeweils nach Massgabe des mit der Stellgrösse und der Summe der Quadrate der Abgriffssignalelemente bewerteten Ausgangssignalfehlers zu korrigieren, um so die Filtereinstellung weiter zu fördern.

Im Hinblick auf die erforderliche Speicherkapazität ist es von Vorteil, nur die von Null verschiedenen Teilsummensignale abzuspeichern bzw. bei vorzeichensymmetrischem Digitalsignal sich nur in ihren Vorzeichen unterscheidende Teilsummensignale nur einmal abzuspeichern und während jedes Laufzeitschrittes die sukzessive ausgelesenen Teilsummen-Signale nach Massgabe der jeweiligen tatsächlichen Kombination von Digitalsignalelementen zur Bildung des Ausgangssignalelements bzw. des jeweils neu abzuspeichernden korrigierten Teilsummensignals zu addieren bzw. subtrahieren.

Die erfindungsgemässe Schaltungsanordnung ist im Patentanspruch 7 angegeben.

Anhand der Zeichnungen sei die Erfindung noch näher erläutert. Dabei zeigt

Fig. 1 ein bekanntes Transversalfilter;

Fig. 2 zeigt ein Ausführungsbeispiel eines Transversalfilters gemäss der Erfindung.

Die Zeichnung Fig. 1 zeigt zur Verdeutlichung der bekannten Transversalfiltertechnik schematisch ein (N-1)-stufiges adaptives Transversalfilter mit einer mit Abgriffen $a_k$, $a_{k-1}$, $a_{k-2}$, $a_{k-3}$,–, $a_{k-N+2}$, $a_{k-N+1}$ versehenen Kette von Laufzeitgliedern der Verzögerungszeit $\tau$, deren Abgriffe über einstellbare Bewertungsglieder $c_0$, $c_1$, $c_2$, $c_3$–$c_{N-2}$, $c_{N-1}$ zu einer Summiereinrichtung $\Sigma$ führen; am Filtereingang $a_k$ schrittweise zugeführte Eingangs-Digitalsignalelemente werden zeitlich jeweils um ein (weiteres) Zeitelement $\tau$ versetzt an den nachfolgenden Abgriffen $a_{k-1}$,–$a_{k-N+1}$ der Laufzeitkette abgegriffen, wobei in jedem Zeitelement sämtliche gerade abgegriffenen Digitalsignalelemente in den Bewertungsgliedern $c_0$–$c_{N-1}$ nach Massgabe der eingestellten Filterkoeffizienten bewertet, d.h. jeweils mit dem betreffenden Filterkoeffizienten multipliziert werden, um so dann im Summierglied $\Sigma$ zu dem in diesem Zeitelement auftretenden Ausgangs-Digitalsignalelement aufsummiert zu werden, wie dies eingangs bereits angesprochen wurde. Damit das Digitalsignal richtig verarbeitet, d.h. (im Zeitbereich) gefiltert wird, müssen die Filterkoeffizienten richtig eingestellt sein. Bei einem adaptiven Transversalfilter, wie es in Fig. 1 skizziert ist, geht dies automatisch in einer Iteration vor sich, in der in jedem Zeitelement, d.h. mit jedem Laufzeitschritt wiederholt, in Abhängigkeit von der Differenz $\Delta\sigma_k$, um die das jeweils am Filterausgang $\sigma_k$ auftretende Digitalsignalelement von einem (beispielsweise mit einem als Schmitt-Trigger zu realisierenden Entscheider bestimmten) Sollwert abweicht, die einzelnen Filterkoeffizienten korrigiert werden, wobei gemäss Fig. 1 der Fehler $\Delta\sigma_k$, mit dem jeweiligen Abgriffssignalelementwert $a_{k-i}$ und der Einstellgrösse g multipliziert, den jeweiligen Korrekturwert für den betreffenden bisherigen Filterkoeffizienten ergibt, wie dies ebenfalls eingangs bereits angesprochen wurde. Im Transversalfilter gemäss Fig. 1 muss die Summiereinrichtung $\Sigma$ in jedem Zeitelement $\tau$, d.h. je Laufzeitschritt, bei der (seriellen) Aufsummierung der einzelnen bewerteten Abgriffssignalelemente insgesamt N Additionen (bzw. Subtraktionen) durchführen, und es sind zur Koeffizienteneinstellung je Laufzeitschritt ebenfalls N arithmetische Operationen zur Korrektur der N Filterkoeffizienten durchzuführen.

Mit einer vergleichsweise jeweils geringeren Anzahl arithmetischer Operationen gelingt die Digitalsignalverarbeitung nach Art eines Transversalfilters mit einer Schaltungsanordnung gemäss der Erfindung.

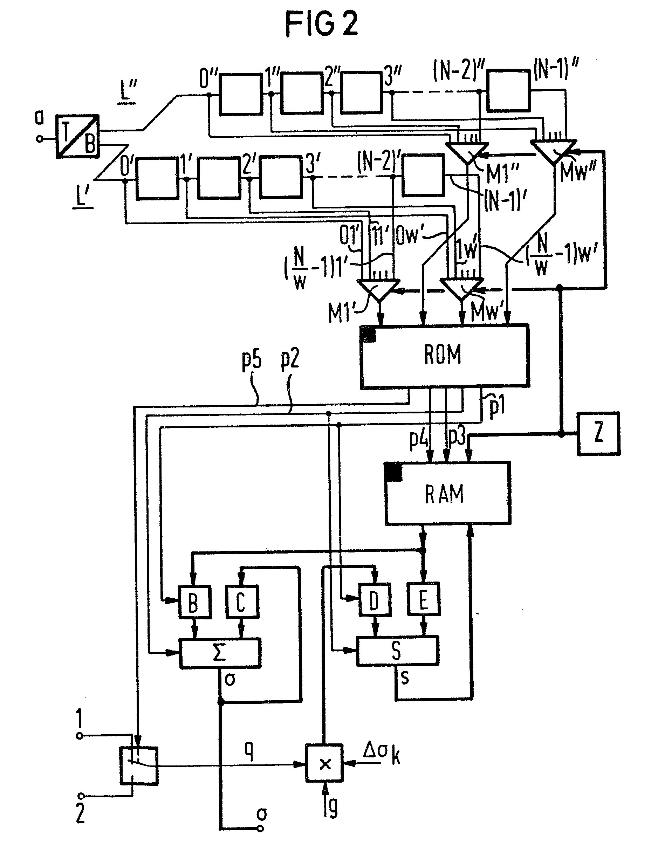

Die Zeichnung Fig. 2 zeigt schematisch in einem zum Verständnis der Erfindung erforderlichen Umfange ein Ausführungsbeispiel einer Schaltungsanordnung gemäss der Erfindung zur Digitalsignalverarbeitung nach Art eines adaptiven Transversalfilters. Diese Schaltungsanordnung weist zunächst eine an ihrem Eingang mit dem zu verarbeitenden Digitalsignal beaufschlagte, mit Abgriffen (0, 1, 2, 3,–N-2, N-1) versehene (N-1)-stufige Laufzeitkette (L) auf. In Fig. 2 ist dazu angedeutet, dass in einem Codewandler T/B ein am Eingang a der Laufzeitkette (L) als zu verarbeitendes Digitalsignal zugeführtes Ternärsignal zunächst in ein ein binäres Betragssignal und ein binäres Vorzeichensignal umfassendes Binärsignalpaar umcodiert wird; die Laufzeitkette (L) weist dann einen mit dem binären Vorzeichensignal beaufschlagten (N-1)-stufigen Zweig L' und einen mit dem binären Betragssignal beaufschlagten (N-1)-stufigen Zweig L'' auf. Eine jede Gruppe von w aufeinanderfolgenden Abgriffen der N/w Gruppen von Abgriffen aufweisenden Laufzeitkette (L) ist mit jeweils dieser Gruppe von Abgriffen zugehörigen Eingängen einer N/w Gruppen von Eingängen aufweisenden Scanningeinrichtung (M) verbunden. Wie in Fig. 2 angedeutet ist, kann diese Scanningeinrichtung (M) für jeden Zweig L', L'' der Laufzeitkette jeweils w durch einen Zähler Z im Gleichtakt gesteuerte Multiplexer M1', Mw', M1'', Mw'' mit jeweils N/w Eingängen aufweisen, deren jeweilige Eingänge an die einander entsprechenden Abgriffe der einzelnen Gruppe von Abgriffen angeschlossen sind: Im Ausführungsbeispiel gemäss Fig. 2, in dem jeweils w = 2 aufeinanderfolgende Abgriffe zu einer Gruppe zusammengefasst sind, sind dabei die eine solche Gruppe bildenden Abgriffe 0', 1' des N/w = N/2 solche Gruppen von Abgriffen 0', 1'; ...; (N-2)', (N-1)' aufweisenden Laufzeitkettenzweiges L' mit den dieser Gruppe von Abgriffen zugehörigen Eingängen 01', Ow' der beiden Multiplexer M1' und Mw' der Scanningeinrichtung (M) verbunden, und es ist die darauffolgende Gruppe der beiden Abgriffe 2', 3' mit den Multiplexer-Eingängen 11', 1w' verbunden, und so fort; schliesslich sind die die letzte Gruppe von Abgriffen bildenden Abgriffe (N-2)' und (N-1)' mit den Eingängen $(\frac{N}{w} - 1)1'$ und $(\frac{N}{w} - 1)w'$ der beiden Multiplexer M1' und Mw' verbunden. Wie aus Fig. 2 ersichtlich ist, gilt entsprechendes auch für die Verbindungen der Abgriffe 0'', 1''; 2'', 3''; ...; (N-2)'', (N-1)'' des Laufzeitkettenzweiges L'' und die entsprechenden Eingänge der Multiplexer M1'' und Mw'', ohne dass dies hier noch im einzelnen ausgeführt werden müsste. Die gemäss Fig. 2 durch die vier Mutliplexer M1'–M2w'' gebildete Scanningeinrichtung möge $\frac{N}{w}$ -fach schneller als die Laufzeitkette L', L'' sein, so dass je Laufzeitschritt, d.h. in jedem Laufzeitelement, jeweils alle Abgriffe der Laufzeitkette abgetastet werden.

Ausgangsseitig führen die Multiplexer M1', ... Mw'' der Scanningeinrichtung zu einer im Ausführungsbeispiel nach Fig. 2 durch einen Festwertspeicher gebildeten gemeinsamen Codiereinrichtung ROM, in der das von der Scanningeinrichtung (M) jeweils gerade abgetastete Paar zweier aufeinanderfolgender Ternärsignalelemente, genauer gesagt, das einem solchen Ternärsignalelementepaar entsprechende Quadrupel von an den entsprechenden Abgriffen der beiden Laufzeitkettenzweige L', L'' auftretenden Binärsignalelementen, in der aus Tabelle 1 ersichtlichen Weise umcodiert werden möge.

Tabelle 1

| Ternärsignal-gruppe | | Vorzeichen | | | | Betrag | | | | |
|---|---|---|---|---|---|---|---|---|---|---|
| $t_{k-i}$ | $t_{k-i-1}$ | m1' | mw' | m1'' | mw'' | $p_1$ | $p_2$ | $p_3$ | $p_4$ | $p_5$ |
| +1 | +1 | 0 | 0 | L | L | L | 0 | L | L | L |
| +1 | 0 | 0 | 0 | L | 0 | L | 0 | L | 0 | 0 |
| +1 | −1 | 0 | L | L | L | L | 0 | 0 | L | L |
| 0 | +1 | 0 | 0 | 0 | L | L | 0 | 0 | 0 | 0 |
| 0 | 0 | 0 | 0 | 0 | 0 | 0 | . | . | . | . |
| 0 | −1 | 0 | L | 0 | L | L | L | 0 | 0 | 0 |
| −1 | +1 | L | 0 | L | L | L | L | 0 | L | L |
| −1 | 0 | L | 0 | L | 0 | L | L | L | 0 | 0 |
| −1 | −1 | L | L | L | L | L | L | L | L | L |

Darin sind in den Spalten $t_{k-i}$ und $k_{k-i-1}$ die möglichen Paare aufeinanderfolgender Ternärsignalelemente angegeben und in den Spalten m1', mw', m1'' und mw'' die ihnen entsprechenden, gemäss Fig. 2 an den Ausgängen der Multiplexer M1', Mw', M1'' und Mw'' auftretenden Vorzeichen- und Betragssignalbits. Die den einzelnen Quadrupeln von Vorzeichen- und Betragssignalbits entsprechenden, an den Ausgängen p1,–p5 der Codiereinrichtung ROM auftretenden Steuerbits sind in Tabelle 1 in den Spalten $p_1, \ldots p_5$ angegeben. Dabei dienen die Steuerbits $p_3$ und $p_4$, in Ergänzung einer jeweils vom Zähler Z abgegebenen Gruppenadresse, der Ansteuerung der einzelnen Speicherplätze eines Teilsummensignalspeichers RAM.

In diesem bei adaptiver Signalfilterung als Lese-Schreib-Speicher ausgebildeten Speicher RAM sind die den $A^w \cdot N/w$ möglichen Kombinationen jeweils w aufeinanderfolgender Signalelemente eines A-wertigen Digitalsignals von N/w aufeinanderfolgenden Gruppen von Digitalsignalelementen entsprechenden Teilsummensignale aus den jeweils zugehörigen, nach Massgabe der jeweiligen Filtereinstellung bewerteten Abgriffssignalelementen gespeichert. In dem hier betrachteten Ausführungsbeispiel mit w = 2 und A = 3 sind somit im Teilsummensignalspeicher RAM unter jeder Gruppenadresse, d.h. jeweils für eine j-te Gruppe von Abgriffen (mit j = $0, \ldots \frac{N}{w} - 1$), im Prinzip jeweils die in Tabelle 2 in Spalte F genannten Teilsummen gespeichert, worin die einzelnen Summanden c die dem jeweiligen Index entsprechenden Filterkoeffizienten darstellen, die in einem Transversalfilter gemäss Fig. 1 explizite gespeichert wären. Man erkennt, dass im Prinzip jeweils die $A^w = 3^2 = 9$ möglichen Kombinationen jeweils w = 2 aufeinanderfolgender Ternärsignalelemente entsprechenden Teilsummen aus den jeweils zugehörigen, nach Massgabe der Filtereinstellung bewerteten, d.h. mit den jeweiligen Filterkoeffizienten c multiplizierten w = 2 Abgriffsignalelementen $t_{k-2j}$, $t_{k-2j-1}$ abgespeichert sind, von denen dann jeweils nach Massgabe des Steuerbitpaares $p_3$, $p_4$ – und damit nach Massgabe der jeweils abgetasteten Abgriffssignalelemente – eine Teilsumme ausgelesen wird.

Tabelle 2

| Ternärsignal gruppe | | | | | |
|---|---|---|---|---|---|
| $t_{k-2j}$ | $t_{k-2j-1}$ | $p_3$ | $p_4$ | $F(k,j)$ | |
| +1 | +1 | L | L | $+c_{2j}$ | $+c_{2j+1}$ |
| +1 | 0 | L | 0 | $+c_{2j}$ | |
| +1 | −1 | 0 | L | $+c_{2j}$ | $-c_{2j+1}$ |
| 0 | +1 | 0 | 0 | | $+c_{2j+1}$ |
| 0 | 0 | · | · | 0 | |
| 0 | −1 | 0 | 0 | | $-c_{2j+1}$ |
| −1 | +1 | 0 | L | $-c_{2j}$ | $+c_{2j+1}$ |
| −1 | 0 | L | 0 | $-c_{2j}$ | |
| −1 | −1 | L | L | $-c_{2j}$ | $-c_{2j+1}$ |

In Tabelle 2 sind für die jeweils 9 möglichen Ternärsignalgruppen $t_{k-2j}$, $k_{k-2j+1}$ (mit j = 0, . . ., $\frac{N}{w}$ -1) und die gemäss Tabelle 1 zugehörigen Steuerbits $p_3$, $p_4$ in der Spalte F die jeweils resultierenden, allgemein mit

$$F(k, j) = \sum_{v=0}^{w-1} a_{k-wj-v} \cdot c_{wj+v}$$

zu beschreibenden Teilsummen aus den jeweils mit einem Filterkoeffizienten c bewerteten Abgriffssignalelementen a jeweils einer Gruppe von w solchen Signalelementen angegeben.

Der für die Abspeicherung der Teilsummen erforderliche Speicherbedarf verringert sich, wenn nur die von Null verschiedenen Teilsummensignale abgespeichert werden und wenn bei vorzeichensymmetrischem Digitalsignal sich nur in ihrem Vorzeichen unterscheidende Teilsummensignale nur einmal abgespeichert werden, wobei dann während jedes Laufzeitschrittes die sukzessive ausgelesenen Teilsummen-Signale nach Massgabe der jeweiligen tatsächlichen Kombination von Digitalsignalelementen zur Bildung eines Ausgangssignalelements bzw. eines jeweils neu abzuspeichernden korrigierten Teilsummensignals addiert oder subtrahiert werden; in dieser Weise arbeitet auch die Schaltungsanordnung gemäss Fig. 2, wie dies auch aus den nachfolgenden Erläuterungen ersichtlich wird:

Der Ausgang des Teilsummensignalspeichers RAM ist mit dem einen Eingangsregister B einer Signalsummierschaltung Σ verbunden, von deren Ausgang σ eine Verbindung zu dem anderen Eingangsregister C zurückführt und die damit seriell die für jeden Laufzeitschritt, d.h. jeweils während eines Laufzeitelements, aus dem Teilsummensignalspeicher RAM ausgelesenen Teilsummensignale aufsummiert, wobei das am Ausgang p2 der Codiereinrichtung ROM jeweils gerade auftretende Steuerbit ($p_2$ in Tabelle 1) angibt, ob die jeweils im Eingangsregister B stehende Teilsumme (bei $p_2$ = 0) addiert oder (bei $p_2$ = L) subtrahiert wird; durch ein am Ausgang p1 der Codiereinrichtung ROM auftretendes Steuerbit ($p_1$ = 0 in Tabelle 1) wird, wenn die momentan erreichte Faltungssumme unverändert bleiben soll, das Eingangsregister B gesperrt, so dass es weder zu einer Addition noch zu einer Subtraktion kommt. Sind so im Verlaufe eines Laufzeitelements die den an den Abgriffen 0', . . ., (N-1)'; 0'', . . ., (N-1)'' der Laufzeitkette L'; L'' auftretenden Digitalsignalelementen entsprechenden Teilsignalsummen aufsummiert worden, d.h., sind so für den betreffenden Laufzeitschritt nach Massgabe der jeweiligen N/w tatsächlichen Kombinationen von Ternärsignalelementen die zugehörigen Teilsummensignale sukzessiv ausgelesen und miteinander aufsummiert worden, so erhält man schliesslich am Ausgang σ der Schaltungsanordnung das entsprechende verarbeitete, d.h. «gefilterte», Ausgangs-Signalelement.

Damit das Eingangs-Digitalsignal richtig zum Ausgangs-Digitalsignal verarbeitet, d.h. gewissermassen (im Zeitbereich) gefiltert wird, müssen im Teilsummensignalspeicher RAM die dem gewünschten Filterverhalten entsprechenden Teilsummensignale abgespeichert sein. In der Schaltungsanordnung gemäss Fig. 2 werden die Teilsummensignale in einem Adaptionsvorgang iterativ dadurch gebildet, dass jedes der sukzessive ausgelesenen Teilsummensignale mit einem Korrekturwert kombiniert ein korrigiertes Teilsummensignal bildet, das anstelle des ausgelesenen Teilsummensignals als neues Teilsummensignal abgespeichert wird. Hierzu ist der Ausgang des Teilsummensignalspeichers RAM mit dem einen Eingangsregister E einer ebenfalls von der Codiereinrichtung ROM steuerbaren Signalsummierschaltung S verbunden, die ein zweites Eingangsregister D für das während jedes Laufzeitschrittes auftretende, mit einer Stellgrösse g bewertete Fehlersignal $\triangle\sigma_k$ aufweist und deren Ausgang s zum Einschreibeingang des Teilsummensignalspeichers RAM führt. Das Fehlersignal $\triangle\sigma_k$ kann dabei in ähnlicher Weise gebildet werden, wie dies oben anhand von Fig. 1 erläutert wurde, ohne dass hier noch näher darauf eingegangen werden müsste; es sei lediglich bemerkt, dass das Fehlersignal $\triangle\sigma_k$ auch jeweils gemittelt sein kann und/oder auch nur seinem Vorzeichen nach wirksam zu sein braucht, was hier jedoch ebenfalls nicht näher verfolgt werden muss.

Wie aus Fig. 2 ersichtlich ist, kann das Fehlersignal $\triangle\sigma_k$ zusätzlich zur Bewertung mit der Stellgrösse g auch noch mit einer Grösse q bewertet, d.h. multipliziert, werden, wobei gemäss Fig. 2 in Abhängigkeit von dem von der Codiereinrichtung ROM jeweils gerade ausgegebenen Steuerbit $p_5$ die Grösse q (bei $p_5 = 0$) den Wert 1 oder (bei $p_5 = L$) den Wert 2 hat. Wie aus Tabelle 1 ersichtlich ist, ist die Grösse q gleich der Summe der Quadrate der gerade abgetasteten w = 2 Abgriffssignalelemente; durch die zusätzliche Bewertung des Fehlersignals mit dieser Summe der Quadrate der Abgriffssignalelemente – oder, allgemein gesprochen, mit dem Skalarprodukt $\underline{a}_{k,j}^T \cdot \underline{a}_{k,j}$ des mit seinen Teilkomponenten $a_{k-wj-v}$ (mit v = 0, . . ., w-1) das Kollektiv der in einem k-ten Zeitelement an den Abgriffen der Laufzeitkette (L) auftretenden Digitalsignalelemente beschreibenden Vektors (Zeilenvektor $\underline{a}_{k,j}^T$ ) mit sich selbst (Spaltenvektor $\underline{a}_{k,j}$) – kann die – dann allgemein jeweils mit

$$F(k,j)_{neu} = F(k,j)_{alt} - g \cdot \triangle\sigma_k \cdot \underline{a}_{k,j}^T \cdot \underline{a}_{k,j}$$

zu beschreibende – Teilsummenadaption erforderlichenfalls beschleunigt werden.

In Tabelle 2 waren die bei dreiwertigem Digitalsignal (Ternärsignal) und gruppenweiser Zusammenfassung von jeweils w = 2 Abgriffssignalelementen 9 möglichen Teilsummen F(k,j) dargestellt worden. Ist stattdessen ein zweiwertiges, d.h. nur die beiden Werte +1 und −1 aufweisendes Digitalsignal (Binärsignal) zu verarbeiten, wobei in Abweichung von Fig. 2 dann unter Wegfall des Codewandlers T/B nur ein einziger Laufzeitkettenzweig vorgesehen zu werden braucht, so sind bei gruppenweiser Zusammenfassung von ebenfalls jeweils w = 2 Abgriffssignalelementen nur die vier zweigliedrigen Teilsummen F der Tabelle 2 möglich. Allgemein erfordert die Abspeicherung der Teilsummen bei einem A-wertigen, vorzeichensymmetrischen Digitalsignal eine Speicherkapazität von

$$\frac{1}{2} \cdot A^w \cdot N/w \text{ Teilsummen}$$

bei geradzahliger Wertigkeit A deszu verarbeitenden Digitalsignals, wobei der Faktor $\frac{1}{2}$ daher rührt, dass, wie schon gesagt wurde, bei Vorzeichensymmetrie des Digitalsignals nur die Hälfte der möglichen Teilsummenwerte abzuspeichern ist. Bei ungeradzahliger Wertigkeit A verringert sich die Anzahl der abzuspeichernden jeweils möglichen Teilsummenwerte um 1, da der Wert 0 nicht abgespeichert zu werden braucht; erforderlich ist dann eine Speicherkapazität von

$$\frac{1}{2}(A^w-1)N/w \text{ Teilsummen.}$$

In der folgenden Übersicht ist für unterschiedliche Gruppenlängen w die Anzahl N/w der je Laufzeitschritt erforderlichen arithmetischen Operationen sowie die für die Teilsummenspeicherung erforderliche Speicherkapazität zum einen für ein symmetrisches Binärsignal und zum anderen für ein symmetrisches Ternärsignal angegeben:

| rithm. Operationen | | Speicherkapazität | |
|---|---|---|---|
| w | N/w | $\frac{N}{2} \cdot 2^w/w$ | $\frac{N}{2}(3^w-1)/w$ |
| 1 | N | N | N |
| 2 | N/2 | N | 2·N |
| 4 | N/4 | 2·N | 10·N |
| 8 | N/8 | 16·N | 410·N |
| 16 | N/16 | 2048·N | 1 345 210·N |

Man sieht, dass sich bei w = 2 eine Halbierung der Anzahl der jeweils erforderlichen arithmetischen Operationen (im Vergleich zu einem w = 1 entsprechenden bekannten Transversalfilter) ergibt, wobei sich bei Filterung eines Binärsignals die erforderliche Speicherkapazität nicht erhöht, während sie sich bei Filterung eines Ternärsignals verdoppelt:

## Patentansprüche

1. Verfahren zur Digitalsignalverarbeitung nach Art eines vorzugsweise adaptiven Transversalfilters mit einer eingangsseitig mit dem zu verarbeitenden Digitalsignal beaufschlagten, mit Abgriffen versehenen (N-1)-stufigen Laufzeitkette, unter Abspeicherung von Teilsummensignalen, die aus jeweils einer Gruppe gleichzeitig abgreifbarer, nach Massgabe der jeweiligen Filtereinstellung bewerteter Abgriffssignalelemente gebildet sind, wobei während der Laufzeitschritte nach Massgabe der tatsächlichen Kombinationen von Abgriffssignalelementen die zugehörigen Teilsummensignale sukzessive ausgelesen und miteinander zu Ausgangssignalelementen aufsummiert werden, gekennzeichnet durch die Abspeicherung solcher Teilsummensignale, die N/w (mit w < N) aufeinanderfolgenden Gruppen von jeweils $A^w$ möglichen Kombinationen jeweils w aufeinanderfolgender A-wertiger Abgriffssignalelemente entsprechen, und dadurch, dass während jedes Laufzeitschrittes N/w aufeinanderfolgende Gruppen jeweils w aufeinanderfolgender Abgriffssignalelemente sukzessive abgegriffen werden und nach Massgabe der N/w tatsächlichen Kombinationen von Abgriffssignalelementen die zugehörigen Teilsummensignale sukzessive ausgelesen und miteinander zu einem Ausgangssignalelement aufsummiert werden.

2. Verfahren nach Anspruch 1, gekennzeichnet durch die iterative Bildung von Teilsummensignalen dadurch, dass jedes der sukzessive ausgelesenen Teilsummensignale mit einem Korrekturwert kombiniert ein korrigiertes Teilsummensignal bildet, das anstelle des ausgelesenen Teilsummensignals als neues Teilsummensignal abgespeichert wird.

3. Verfahren nach Anspruch 2, dadurch gekennzeichnet, dass während jedes Laufzeitschrittes die einzelnen Teilsummensignale jeweils nach Massgabe des während dieses Laufzeitschrittes auftretenden, mit einer Stellgrösse bewerteten Ausgangssignalfehlers korrigiert werden.

4. Verfahren nach Anspruch 3, dadurch gekennzeichnet, dass die einzelnen Teilsummensignale jeweils nach Massgabe des mit der Stellgrösse und der Summe der Quadrate der Abgriffssignalelemente bewerteten Ausgangssignalfehlers korrigiert werden.

5. Verfahren nach einem der Ansprüche 1 bis 4, dadurch gekennzeichnet, dass bei vorzeichensymmetrischem Digitalsignal sich nur in ihrem Vorzeichen unterscheidende Teilsummensignale nur einmal abgespeichert werden und dass während jedes Laufzeitschrittes die sukzessive ausgelesenen Teilsummen-Signale nach Massgabe der jeweiligen tatsächlichen Kombination von Digitalsignalelementen zur Bildung des Ausgangssignalelements bzw. des jeweils neu abzuspeichernden korrigierten Teilsummensignals addiert oder subtrahiert werden.

6. Verfahren nach einem der Ansprüche 1 bis 5, gekennzeichnet durch die Abspeicherung nur der von Null verschiedenen Teilsummensignale.

7. Schaltungsanordnung zur Digitalsignalverarbeitung nach Art eines vorzugsweise adaptiven Transversalfilters mit einer an ihrem Eingang mit dem zu verarbeitenden Digitalsignal beaufschlagten, mit Abgriffen versehenen (N-1)-stufigen Laufzeitkette, dadurch gekennzeichnet, dass jeweils eine Gruppe von w aufeinanderfolgenden Abgriffen (0, 1; 2, 3; ...) der N/w Gruppen von Abgriffen (0, 1; ...; N-2, N-1) aufweisenden Laufzeitkette (L) mit jeweils dieser Gruppe von Abgriffen (0, 1; 2, 3;–) zugehörigen Eingängen (01, Ow; 11, 1w–) einer N/w Gruppen von Eingängen (01, Ow;–; $(\frac{N}{w}$ -1)1; $(\frac{N}{w}$ -1)w) aufweisenden, gegenüber der Laufzeitkette (L) $\frac{N}{w}$ - fach schnelleren Scanningeinrichtung (M) verbunden sind, die ausgangsseitig über eine Codiereinrichtung (ROM) die Ansteuerung eines die den $A^w \cdot$ N/w möglichen Kombinationen jeweils w aufeinanderfolgender Signalelemente eines A-wertigen Digitalsignals von N/w aufeinanderfolgenden Gruppen von Digitalsignalelementen entsprechenden Teilsummensignale aus den jeweils zugehörigen, nach Massgabe der jeweiligen Filtereinstellung bewerteten Abgriffssignalelementen speichernden Teilsummensignalspeichers (RAM) nach Massgabe der jeweils abgetasteten Abgriffssignalelemente bewirkt, wobei der Ausgang des Teilsummensignalspeichers (RAM) mit dem einen Eingang (B) einer ebenfalls von der Codiereinrichtung (ROM) steuerbaren, von ihrem Ausgang ($\sigma$) zu ihrem anderen Eingang (C) zurückgeführten und damit die während eines Laufzeitschrittes ausgelesenen Teilsummensignale summierenden Signalsummierschaltung ($\Sigma$) verbunden ist, an deren Ausgang ($\sigma$) das verarbeitete Ausgangssignal auftritt.

8. Schaltungsanordnung nach Anspruch 7, dadurch gekennzeichnet, dass der Ausgang des Teilsummensignalspeichers (RAM) mit dem einen Eingang (E) einer ebenfalls von der Codiereinrichtung (ROM) steuerbaren, einen zweiten Eingang (D) für das während jedes Laufzeitschrittes auftretende, mit einer Stellgrösse (g) bewertete Fehlersignal ($\triangle \sigma_k$) aufweisenden Signalsummierschaltung (S) verbunden ist, deren Ausgang (s) zum Einschreibeingang des Teilsummensignalspeichers (RAM) führt.

9. Schaltungsanordnung nach Anspruch 8, dadurch gekennzeichnet, dass der zweite Eingang (D) der Signalsummierschaltung (S) mit einem mit der Stellgrösse (g) und der Summe der Quadrate der Abgriffssignalelemente bewerteten Fehlersignal ($\triangle \sigma_k$) beaufschlagt ist.

10. Schaltungsanordnung nach einem der Ansprüche 7 bis 9, dadurch gekennzeichnet, dass die Scanningeinrichtung (M) w im Gleichtakt gesteuerte Multiplexer (M1, Mw) mit jeweils N/w Eingängen aufweist, deren jeweilige Eingänge (01', 11', ...; Ow', 1w', ...) an die einander entsprechenden Abgriffe (0', 2', ...; 1', 3', ...) der einzelnen Gruppen von Abgriffen 0', 1'; 2', 3'; ...) angeschlossen sind.

11. Schaltungsanordnung nach einem der Ansprüche 7 bis 10, dadurch gekennzeichnet, dass die Codiereinrichtung (ROM) durch einen ROM-Speicher gebildet ist.

12. Schaltungsanordnung nach einem der Ansprüche 7 bis 11 zur Verarbeitung eines Ternärsignals, dadurch gekennzeichnet, dass die Laufzeitkette (L) einen mit einem binären Betragssignal beaufschlagten (N-1)-stufigen Zweig (L") und einen mit einem binären Vorzeichensignal beaufschlagten (N-1)-stufigen Zweig (L') aufweist, die jeweils mit einer eigenen, zu der gemeinsamen Codiereinrichtung (ROM) führenden Scanningeinrichtung M1', Mw'; M1", Mw") verbunden sind.

**Revendications**

1. Procédé pour traiter un signal numérique à la façon d'un filtre transversal, de préférence adaptatif, au moyen d'une ligne à retard à (N-1) étages, qui est alimentée à son entrée avec le signal numérique à traiter et est pourvue de prises, avec mémorisation de signaux de sommes partielles qui sont formés chaque fois d'un groupe d'éléments de signal de prélèvement pouvant être prélevés simultanément et qui sont pondérés en fonction de l'ajustement du filtre, procédé selon lequel, pendant les pas du temps de propagation, les signaux de sommes partielles correspondants sont lus successivement en fonction des combinaisons effectives d'éléments de signal de prélèvement, et sont totalisés entre eux, pour donner des éléments de signal de sortie, caractérisé par la mémorisation de signaux de sommes partielles qui correspondent à N/w (avec w < N) groupes qui se suivent de chaque fois $A^w$ combinaisons possibles de chaque fois w éléments de signal de prélèvement qui se suivent de valence A et en ce que, pendant chaque pas du temps de propagation, N/w groupes qui se suivent de chaque fois w éléments de signal de prélèvement qui se suivent sont prélevés successivement et les signaux de sommes partielles correspondants sont lus successivement et sont totalisés ensemble en un élément de signal de sortie en fonction des N/w combinaisons effectives d'éléments de signal de prélèvement.

2. Procédé selon la revendication 1, caractérisé par la formation itérative de signaux de sommes partielles par le fait que chacun des signaux de sommes partielles lus successivement forme, combiné avec une valeur correctrice, un signal de somme partielle corrigé qui est mémorisé en tant que nouveau signal de somme partielle à la place du signal de somme partielle lu.

3. Procédé selon la revendication 2, caractérisé en ce que, pendant chaque pas du temps de propagation, les différents signaux de sommes partielles sont corrigés chaque fois en fonction d'une erreur de signal de sortie, pondérée d'une grandeur de réglage, apparaissant pendant ce pas du temps de propagation.

4. Procédé selon la revendication 3, caractérisé en ce que les différents signaux de sommes partielles sont corrigé chaque fois en fonction de l'erreur du signal de sortie, pondérée par la grandeur de réglage et la somme des carrés des éléments de signal de prélèvement.

5. Procédé selon une des revendications 1 à 4, caractérisé en ce que, dans le cas d'un signal numérique symétrique quant au signe, seuls sont mémorisés, une fois seulement, les signaux de sommes partielles qui se distinguent par leur signe et que, pendant chaque pas du temps de propagation, les signaux de sommes partielles lus successivement sont additionnés ou soustraits en fonction de la combinaison effective d'éléments de signal numérique, en vue de la formation de l'élément de signal de sortie, respectivement du signal de somme partielle corrigé qui est à remémoriser à chaque fois.

6. Procédé selon une des revendications 1 à 5, caractérisé par le seule mémorisation des signaux de sommes partielles qui diffèrent de zéro.

7. Montage pour traiter un signal numérique à la façon d'un filtre transversal, de préférence adaptatif, comprenant une ligne à retard, à (N-1) étages, qui est pourvue de prises et qui est alimentée à son entrée avec le signal numérique à traiter, caractérisé en ce qu'un groupe de w prises (0, 1; 2, 3; . . .) qui se suivent de la ligne de retard (L), présentant N/w groupes de prises (0, 1; . . .; N-2, N-1) sont reliées chaque fois à des entrées (01, 0w; 11, 1w . . .), associées à ce groupe de prises (0, 1; 2, 3; . . .), d'un dispositif de balayage (M) qui présente N/w groupes d'entrées (01, 0w; . . .; $(\frac{N}{w} - 1)1$; $(\frac{N}{w} - 1)w$) et qui est $\frac{N}{w}$ fois plus rapide que la ligne à retard (L), dispositif de balayage qui produit, côté sortie, à l'aide d'un dispositif de codage (ROM) l'attaque d'une mémoire de signaux de sommes partielles (RAM), en fonction des signaux de signal de prélèvement échantillonnés chaque fois, mémoire dans laquelle sont mémorisés les signaux de sommes partielles correspondant aux $A^w \cdot N/w$ combinaisons possibles de chaque fois w éléments de signal qui se suivent d'un signal numérique de valence A, parmi N/w groupes qui se suivent d'éléments de signal numérique, les signaux de sommes partielles étant issus des éléments de signal de prélèvement associés et pondérés en fonction de l'ajustement correspondant du filtre, la sortie de la mémoire de signal de sommes partielles (RAM) étant reliée à l'une des entrées (B) d'un circuit de totalisation de signaux (Σ), circuit qui peut également être commandé par le dispositif de codage (ROM) et dont la sortie (σ) est connectée en retour à son entrée (C), de sorte que ce circuit totalise les signaux de sommes partielles lus pendant un pas du temps de propagation, le signal de sortie traité apparaissant sur la sortie (σ) de ce circuit de totalisation.

8. Montage selon la revendication 7, caractérisé en ce que la sortie de la mémoire de signaux de sommes partielles (RAM) est reliée à l'une des entrées (E) d'un circuit de totalisation de signaux (S) qui peut également être commandé par le dispositif de codage (ROM) et qui présente une seconde entrée (D) pour le signal d'erreur ($\triangle\sigma_k$) ap-

paraissant pendant chaque pas du temps de propagation et pondéré par une grandeur de réglage (g), la sortie (s) du circuit de totalisation menant à l'entrée d'inscription de la mémoire de signaux de sommes partielles (RAM).

9. Montage selon la revendication 8, caractérisé en ce que la seconde entrée (D) du circuit de totalisation de signaux est alimentée avec un signal d'erreur ($\triangle\sigma_k$) pondéré par la grandeur de réglage (g) et par la somme des carrés des éléments de signal de prélèvement.

10. Montage selon une des revendications 7 à 9, caractérisé en ce que le dispositif de balayage (M) présente w multiplexeurs (M1, Mw) commandés en synchronisme et présentant chacun N/w entrées, dont les entrées respectives (01', 11', ...; 0w', -) sont connectées aux prises (0', 2', ...; 1', 3', ...) mutuellement correspondantes des différents groupes de prises (0', 1'; 2', 3'; ...).

11. Montage selon une des revendications 7 à 10, caractérisé en ce que le dispositif de commande (ROM) est constitué par une mémoire morte ou mémoire ROM.

12. Montage selon une des revendications 7 à 11 pour traiter un signal ternaire, caractérisé en ce que la ligne à retard (L) présente une branche (L''), à (N-1) étages, est alimentée par un signal binaire de valeur, et une branche (L'), à (N-1) étages, alimentée avec un signal binaire de signe, qui sont chacune reliées à un dispositif de balayage (M1', Mw'; M1'', Mw'') qui leur est propre et mène au dispositif de codage (ROM) commun.

## Claims

1. A method of processing digital signals in the manner of a preferably adaptive transversal filter comprising an (N-1)-stage delay line which is supplied at its input with the digital signal which is to be processed and which is provided with tappings, by storing subsidiary sum signals which are each formed by a group of tapped signal elements which can be tapped simultaneously and which are evaluated in accordance with the respective filter setting, where, during the delay steps, in accordance with the actual combinations of tapped signal elements, the associated subsidiary sum signals are successively read-out and added to one another to form output signal elements, characterised by the storage of those subsidiary sum signals which correspond to N/w (where $w < N$) consecutive groups of $A^w$ respec-tive possible combinations of w respective consecutive A-value tapped signal elements and characterised in that during each delay step N/w consecutive groups of w respective consecutive tapped signal elements are successively tapped and in accordance with the N/w actual combinations of tapped signal elements the associated subsidiary sum signals are successively read-out and added to one another to form an output signal element.

2. A method as claimed in claim 1, characterised by the iterative formation of subsidiary sum signals in that each of the successively read-out subsidiary sum signals forms, combined with a correction value, a corrected subsidiary sum signal which is stored in place of the read-out subsidiary sum signal as new subsidiary sum signal.

3. A method as claimed in claim 2, characterised in that during each delay step the individual subsidiary sum signals are each corrected in accordance with the output signal error which occurs during this delay step and which is evaluated with a control variable.

4. A method as claimed in claim 3, characterised in that the individual subsidiary sum signals are each corrected in accordance with the output signal error which is evaluated with the control variable and the sum of the squares of the tapped signal elements.

5. A method as claimed in one of the claims 1 to 4, characterised in that in the case of a sign-symmetrical digital signal subsidiary sum signals which differ only in respect of their sign are stored only once and that during each delay step the successively read-out subsidiary sum signals are added or subtracted in accordance with the respective actual combination of digital signal elements to form the output signal element or the respective corrected subsidiary sum signal which is to be newly stored.

6. A method as claimed in one of the claims 1 to 5, characterised by the storage only of those subsidiary sum signals which differ from zero.

7. A circuit arrangement for digital signal processing in the manner of a preferably adaptive transversal filter comprising an (N-1)-stage delay line which is supplied at its input with the digital signal which is to be processed, and which is provided with tappings, characterised in that a group of w consecutive tappings (0, 1; 2, 3; ...) of the delay line (L) which comprises N/w groups of tappings (0, 1; ...; N-2, N-1) are in each case connected to respective inputs (01, 0w; 11, 1w ...), assigned to this group of tappings (0, 1; 2, 3; ...), of a scanning device (M) which is provided with N/w groups of inputs (01, 0w; ...; ($\frac{N}{w}$-1); ($\frac{N}{w}$ -1)w and which is $\frac{N}{w}$ times faster than the delay line (L), and which, at its output end, via a coder device (ROM), drives, in accordance with the respective scanned tapped signal elements, a subsidiary sum signal store (RAM) which stores the subsidiary sum signals, corresponding to the $A^w.N/w$ possible combinations of in each case w consecutive signal elements of an A-value digital signal of N/w consecutive groups of digital signal elements, of the respective assigned tapped signal elements which are evaluated in accordance with the respective filter setting, wherein the output of the subsidiary sum signal store (RAM) is connected to the first input (B) of a signal adder cir-cuit ($\Sigma$) which can likewise be controlled by the coder device (ROM), is fed-back from its output ($\sigma$) to its other input (C), and thus adds the subsidiary sum signals which are read-out during a delay step, and at whose output ($\sigma$) the pro-cessed output signal occurs.

8. A circuit arrangement as claimed in claim 7, characterised in that the output of the subsidiary sum signal store (RAM) is connected to the first input (E) of a signal adder circuit (S) which can likewise be controlled by the coder device (ROM) and which has a second input (D) for the error signal ($\triangle \sigma_k$) which occurs during each delay step and which is evaluated with a control variable (g), and whose output (s) leads to the write-in input of the subsidiary sum signal store (RAM).

9. A circuit arrangement as claimed in claim 8, characterised in that the second input (D) of the signal adder circuit (S) is supplied with an error signal ($\triangle \sigma_k$) which is evaluated with the control variable (g) and the sum of the squares of the tapped signal elements.

10. A circuit arrangement as claimed in one of the claims 7 to 9, characterised in that the scanning device (M) includes w multiplexers (M1, Mw) which are controlled in synchronism and which each have N/w inputs, the respective inputs of which (01', 11', . . .; 0w', 1w', . . .) are connected to the mutually corresponding tappings (0', 2', . . .; 1', 3', . . .) of the individual groups of tappings (0', 1'; 2', 3'; . . .).

11. A circuit arrangement as claimed in one of the claims 7 to 10, characterised in that the coder device (ROM) is formed by a ROM-store.

12. A circuit arrangement as claimed in one of the claims 7 to 11 for processing a ternary signal, characterised in that the delay line (L) comprises an (N-1)-stage branch (L'') which is supplied with a binary amount signal and an (N-1)-stage branch (L') which is supplied with a binary sign signal, each of which is connected to a separate scanning device (M1', Mw'; M1'', Mw'') which leads to the common coder device (ROM).

1/2

FIG 1

2/2

FIG 2